# DEMANDE DE BREVET EUROPEEN

(11) **EP 1 744 324 A1**
(43) Date de publication de la demande: **17.01.2007**
(21) Numéro de dépôt: 06116679.9
(22) Date de dépôt: 05.07.2006
(51) Int. Cl.: G11C 17/12, G11C 7/18, G11C 11/4097, H01L 27/112

(54) **Mémoire à lecture seule**

(30) Priorité: 05.07.2005 FR 0552045
(71) Demandeur: ST MICROELECTRONICS S.A., 92120 Montrouge (FR)
(72) Inventeur: Jacquet, François, 38190 Froges (FR)
(74) Mandataire: de Beaumont, Michel

(57) **Abrégé**

L'invention concerne une matrice de cellules d'une mémoire à lecture seule constituées chacune d'un transistor dont une première région (d) de drain ou de source est connectée à une ligne de bit (BL) reliant plusieurs transistors dans une première direction, les grilles (g) des différents transistors étant connectées à des lignes de mot (WL) dans une deuxième direction perpendiculaire à la première, la matrice comportant une répétition d'un motif élémentaire s'étendant sur trois lignes dans chaque direction et comportant neuf transistors disposés de façon que chacune des lignes du motif élémentaire comporte deux cellules, deux transistors voisins de chaque motif dans la première direction partageant une même deuxième région (s) reliée à une ligne de masse et étant reliés à des lignes de bit différentes d'une ligne de mot à l'autre.

## Description

### Domaine de l'invention

La présente invention concerne de façon générale les mémoires à lecture seulement (Read Only Memory) dont les états respectifs des cellules sont fixés lors de la fabrication du circuit intégré contenant la mémoire. L'invention concerne plus particulièrement la réalisation d'un réseau de cellules mémoire constituées de transistors MOS. Elle s'applique que la programmation de chaque cellule soit effectuée par une prise de contact sur l'une des régions de source ou de drain du transistor (mémoire généralement appelée "ROM contact") ou qu'elle soit effectuée par la réalisation d'un via conducteur depuis une prise de contact de source ou de drain jusqu'à une piste métallique véhiculant les signaux (mémoire généralement appelée "ROM via").

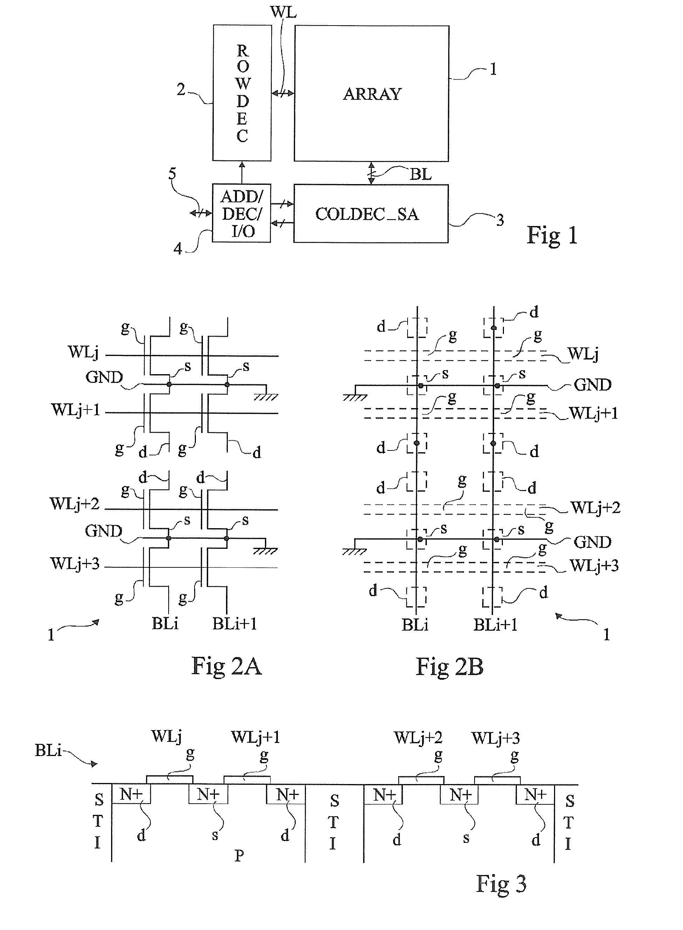

La figure 1 représente de façon très schématique et sous forme de blocs, un exemple de mémoire ROM du type auquel s'applique la présente invention. Une telle structure est destinée à être réalisée sous forme intégrée le cas échéant avec d'autres composants.

Une mémoire ROM comporte principalement un réseau 1 (ARRAY) de cellules mémoire dont des lignes de mot WL (par exemple en rangées) et des lignes de bit BL (par exemple en colonnes) sont respectivement connectées à des circuits 3 et 4 de décodage de rangées (ROWDEC) et de colonnes (COLDEC), le circuit 3 comportant également des amplificateurs de lecture (SA). Les circuits 2 et 3 communiquent avec un circuit d'entrée/sortie 4 (ADD/DEC/I/O) comprenant également un décodeur d'adresses. Ce circuit 4 est relié à un bus 5 d'adresses, de données et de commande, communiquant avec l'extérieur de la mémoire.

### Exposé de l'art antérieur

Les figures 2A et 2B représentent, de façon partielle et schématique, un exemple classique d'architecture d'un réseau 1 de cellules mémoire de type ROM. La figure 2A représente le schéma électrique équivalent des transistors MOS tandis que la figure 2B est une vue de dessus schématique des zones actives et des lignes sur-jacentes de silicium polycristallin et de métallisation de reprise de contact.

Dans l'exemple des figures 2A et 2B, huit cellules mémoire réparties sur deux lignes de bit BLᵢ et BLᵢ₊₁ et quatre lignes de mot WLⱼ, WLⱼ₊₁, WLⱼ₊₂ et WLⱼ₊₃ ont été représentées. Chaque cellule est constituée d'un transistor MOS dont la grille g est reliée à une ligne de mot et dont une des régions de source s et de drain d (par exemple, la source s) est connectée à la masse dans un premier niveau de métallisation de la structure. En figure 2B, le fait qu'une région de drain d ou de source s soit contactée par un niveau de métallisation supérieur a été illustré par un point sur la ligne conductrice correspondante. Comme il ressort de cette figure, toutes les sources s des transistors sont partagées par deux transistors (donc deux cellules mémoire) et sont reliées à la masse par des lignes conductrices parallèles aux lignes de mot. Les grilles des transistors sont réalisées dans une couche de silicium polycristallin. Pour simplifier la représentation des figures, on a volontairement confondu ce niveau de silicium polycristallin avec les lignes de mot alors qu'en pratique ces lignes sont formées dans un niveau de métallisation supérieur et sont connectées aux régions de grille par des vias. Les lignes de bit et de mot perpendiculaires sont réalisées dans deux niveaux de métallisation au-dessus des cellules.

La programmation de chaque cellule s'effectue selon que le drain d du transistor concerné est ou non contacté à la ligne de bit de la cellule correspondante. Dans le cas où le drain se trouve relié à la ligne de bit, la cellule mémoire est programmée dans un état bas. Dans le cas contraire, elle est programmée dans un état haut.

La lecture des cellules mémoire d'un tel réseau s'effectue de la façon suivante. La ligne de bit qui doit être lue est préchargée à un niveau de tension positif par rapport à la masse. Puis, la cellule mémoire à lire est adressée au moyen de la ligne de mot correspondante rendant conducteur le transistor de la cellule par application d'une tension sur sa grille. Dans le cas où la ligne de bit est contactée au drain du transistor, la ligne de bit se décharge par la source de son transistor relié à la masse et un état bas est lu par les amplificateurs (3, figure 1). Dans le cas contraire, la ligne de bit n'est pas déchargée et fourni un état haut.

En figure 2B, on a arbitrairement considéré que les transistors de coordonnées WLⱼ-BLᵢ₊₁, WLⱼ₊₁-ELᵢ et WLⱼ₊₁-ELᵢ₊₁ étaient programmés à l'état zéro (leurs drains sont contactés aux lignes de bit) alors que les autres transistors sont programmés à l'état un.

D'autres exemples classiques d'architecture mémoire sont décrits dans les documents US-A 6 556 468 et US-A 6 363 001.

Un problème des réseaux de cellules mémoire à lecture seule connus est lié à l'électromigration sur les lignes de masse en raison du nombre important de cellules susceptibles de décharger le courant de précharge. Lorsque plusieurs lignes de bit parallèles sont préchargées au niveau haut, l'adressage d'une ligne de mot pour sélectionner les transistors des intersections correspondantes conduit à une décharge de l'état haut entre drain et source de tous les transistors programmés pour donner une valeur nulle. La somme des courants des lignes de bit correspondante se trouve alors véhiculée par la ligne conductrice connectée à la masse. L'intensité de courant à véhiculer par ces lignes connectées à la masse conduit soit à les surdimensionner donc augmenter l'encombrement, soit à limiter le nombre de cellules adressables en parallèle dans le plan mémoire, donc la densité.

Un autre inconvénient des cellules mémoire à lecture seule est lié au couplage entre les lignes de bit voisines du réseau. Ce phénomène provient du fait que, lors de la précharge des lignes de bit pour lecture des cellules mémoire d'une ligne de mot donnée, la décharge d'une ligne de bit dont le transistor de la ligne de mot adressée est contactée à la masse provoque par couplage une diminution du potentiel de précharge maintenue sur la ligne voisine d'un transistor non contacté. Ce phénomène est accru si la ligne sur laquelle un état haut doit être lu est encadrée par deux lignes se déchargeant à la masse. Ce problème est de plus en plus critique avec la miniaturisation des réseaux de cellules mémoire et engendre des erreurs de lecture.

Une solution connue pour pallier cet inconvénient est d'organiser la lecture des cellules mémoire de façon différentielle. Une telle solution requiert toutefois de pouvoir adresser séparément deux transistors d'une même ligne de mot sur deux lignes de bit voisines, ce qui revient à individualiser les lignes de mot. Cela conduit à utiliser deux niveaux de métallisation distincts pour réaliser les conducteurs des lignes de bit de façon à être en mesure de faire un adressage plan par plan. Une telle solution présente l'inconvénient de diminuer la densité de la structure. De plus, elle ne résout pas le problème de l'électromigration sur les conducteurs de masse.

Un autre problème des architectures connues de mémoire à lecture seule est lié à la présence de tranchées d'isolement (STI ou Shallow Trench Isolation) dans la structure intégrée pour séparer les transistors constitutifs des cellules.

La figure 3 illustre ce problème par une vue en coupe très schématique le long d'une ligne de bit d'une structure de transistors MOS à canal N sur un substrat P, utilisée pour un réseau de cellules mémoire à lecture seule. Pour simplifier, les reprises de contact sur les lignes conductrices n'ont pas été représentées.

Les transistors sont réalisés par paires (à source s commune) et les drains d respectifs de deux transistors d'une même paire sont séparés des drains des transistors des paires voisines au moyen de tranchée d'isolement STI dans les deux directions. Cela revient à réaliser deux transistors par caisson défini au moyen de tranchées d'isolement. L'importance des ces tranchées d'isolement engendre un stress physique sur les transistors. Or, plus ce stress est important, moins le courant à dimensions données (largeur et longueur de grille) est important. Ce problème conduit à augmenter les tailles respectives des transistors.

### Résumé de l'invention

La présente invention vise à pallier tout ou partie des inconvénients des architectures classiques de cellules mémoire à lecture seule.

L'invention vise plus particulièrement à répartir le courant de masse de plusieurs cellules lues simultanément.

L'invention vise également à proposer une architecture de cellules mémoire à lecture seule résolvant les problèmes de couplage entre lignes de bit.

L'invention vise également à diminuer le stress physique lié aux tranchées d'isolement de la structure.

L'invention vise en outre à proposer une solution compatible avec des mémoires de type contact et des mémoires de type via.

Pour atteindre tout ou partie de ces objets ainsi que d'autres, la présente invention prévoit une matrice de cellules mémoire à lecture seule constituées chacune d'un transistor dont une première région de drain ou de source est connectée à une ligne de bit reliant plusieurs transistors dans une première direction, les grilles des différents transistors étant connectées à des lignes de mot dans une deuxième direction perpendiculaire à la première, la matrice comportant une répétition d'un motif élémentaire s'étendant sur trois lignes dans chaque direction et comportant neuf transistors disposés de façon que chacune des lignes du motif élémentaire comporte deux cellules, deux transistors voisins de chaque motif dans la première direction partageant une même deuxième région reliée à une ligne de masse et étant reliés à des lignes de bit différentes d'une ligne de mot à l'autre.

Selon un mode de réalisation de la présente invention, l'état d'une cellule dépend de la réalisation ou non d'une liaison entre la région de son transistor reliée à la masse et la ligne de bit.

L'invention prévoit également une mémoire à lecture seule comportant une matrice de cellules, au moins une des extrémités d'un groupe de trois colonnes du motif élémentaire étant connectée à un dispositif de lecture pour sélectionner, parmi les trois lignes de bit, deux lignes de bit à lire à partir de la ligne de mot adressée.

Selon un mode de réalisation de la présente invention, des groupes de cellules mémoire sont agencés par colonne en étant connectés de sorte que la première ligne de bit du premier groupe soit reliée à la troisième ligne de bit du deuxième groupe, la deuxième ligne de bit du premier groupe soit reliée à la première ligne de bit du deuxième groupe et la troisième ligne de bit du premier groupe soit reliée à la deuxième ligne de bit du deuxième groupe, une première colonne de groupes comportant de telles liaisons tous les trois groupes verticalement tandis qu'une deuxième colonne voisine comporte une telle liaison entre chaque groupe.

Selon un mode de réalisation de la présente invention, la connexion à la masse des premières régions est effectuée dans un premier niveau de métallisation tandis que les lignes de bit sont réalisées dans un deuxième niveau de métallisation, les liaisons entre les première et troisième lignes de bit entre les groupes étant réalisées dans un troisième niveau de métallisation.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 qui a été décrite précédemment représente, de façon très schématique et sous forme de blocs, un exemple de mémoire à lecture seule du type auquel s'applique la présente invention ;
les figures 2A et 2B qui ont été décrites précédemment représentent un exemple d'architecture classique de réseau de cellules mémoire à lecture seule ;
la figure 3 qui a été décrite précédemment est une vue en coupe très schématique et partielle de transistors MOS d'un réseau de cellules mémoire classique ;
les figures 4A et 4B représentent partiellement un mode de réalisation d'un réseau de cellules mémoire selon la présente invention ;
les figures 5A, 5B et 5C illustrent, de façon très schématique et sous forme de blocs, l'association de plusieurs groupes de cellules selon un mode de réalisation de la présente invention ; et
la figure 6 est une vue schématique en coupe de transistors MOS constitutifs d'un réseau de cellules mémoire selon un mode de réalisation de l'invention.

Les mêmes éléments ont été désignés par les mêmes références aux différentes figures. Pour des raisons de clarté, seuls les éléments utiles à la compréhension de l'invention ont été représentés aux figures et seront décrits par la suite. En particulier, les circuits de lecture et d'adressage des cellules mémoire d'un réseau selon l'invention n'ont pas été exposés.

### Description détaillée

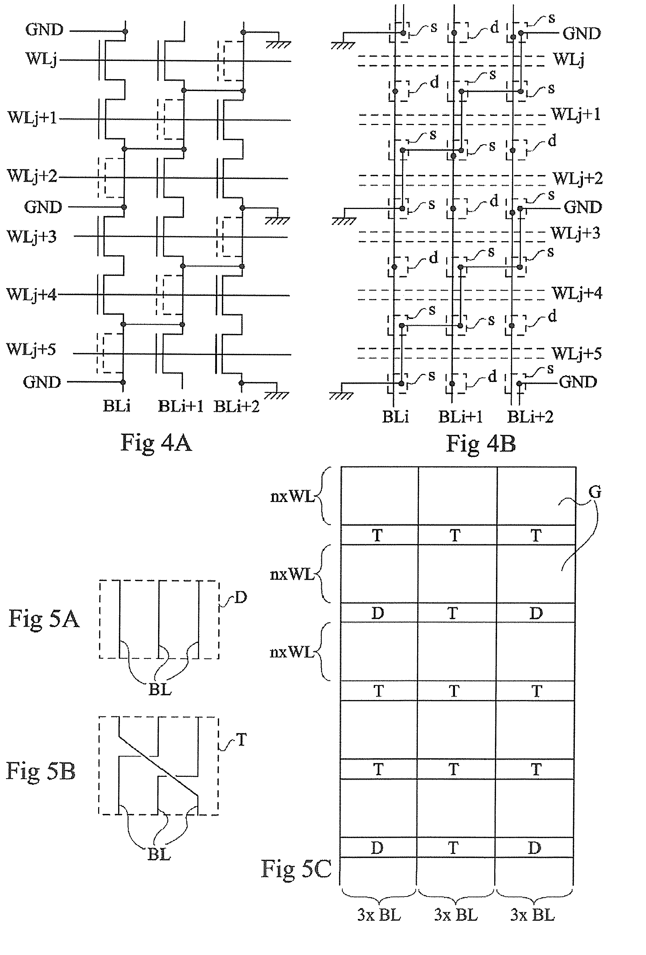

Les figures 4A et 4B représentent, de façon très schématique, un mode de réalisation d'un réseau de cellules mémoire à lecture seule selon la présente invention. Ces figures sont à rapprocher des figures 2A et 2B décrites précédemment et illustrent respectivement le schéma électrique équivalent du réseau de cellules mémoire et une vue de dessus schématique du circuit intégré correspondant.

Comme précédemment, chaque cellule est constituée d'un transistor MOS (par exemple à canal N) dont l'état programmé ou non dépend du report d'un contact depuis une région de drain ou de source jusqu'à une ligne conductrice (ligne de bit) pour conditionner la décharge vers la masse d'un potentiel de précharge de cette ligne. Toutefois, à la différence des structures classiques, cette programmation est effectuée sur la région reliée à une ligne de masse.

Dans l'exemple représenté aux figures 4A et 4B, les sources respectives s des différents transistors sont reliées à la masse (GND) dans un premier niveau de métallisation. Une différence par rapport aux structures connues est que cette liaison à la masse des différentes sources est effectuée en diagonale par rapport aux lignes de mot WLⱼ et aux lignes de bit BLᵢ. Cela revient à prévoir, tous les deux transistors dans la direction des lignes de bit, un transistor dont les deux régions sont interconnectées par la ligne conductrice de masse et ayant donc pour seul objet de connecter entre elles les sources s des deux transistors voisins. En figure 4A, ces transistors sont représentés en pointillés. Dans l'autre direction (parallèle aux lignes de mot), la ligne conductrice de masse interconnecte les sources voisines (communes) de deux transistors voisins. On obtient des lignes conductrices de masse en paliers ayant des directions générales parallèles entre elles dans la diagonale de la matrice.

Une mémoire selon ce mode de réalisation de la présente invention est donc constituée de la répétition d'un motif élémentaire s'étendant sur trois lignes de bit et sur trois lignes de mot (trois rangées et trois colonnes). Ce motif comporte six cellules mémoire (six transistors MOS constituant les points mémoire) réparties aux intersections des rangées et colonnes de façon que chacune des trois rangées et chacune des trois colonnes du motif élémentaire comporte seulement deux cellules. Dans l'exemple représenté aux figures 4A et 4B, la ligne WLⱼ comporte des cellules mémoire aux intersections des lignes BLᵢ et BLᵢ₊₁, la ligne WLⱼ₊₁ comporte des cellules aux intersections des lignes BLᵢ et BLᵢ₊₂ et la ligne WLⱼ₊₂ comporte des cellules aux intersections des colonnes BLᵢ₊₁ et BLᵢ₊₂. Ce motif se répète pour les trois rangées suivantes WLⱼ₊₃, WLⱼ₊₄ et WLⱼ₊₅. Il se répète également dans l'autre direction (non représentée) par groupes de trois lignes de bit.

La programmation des points mémoire d'une architecture selon l'invention s'effectue non plus en contactant les drains d des différents transistors qui sont ici tous connectés aux lignes de bit auxquels ils correspondent, mais en contactant la source s du transistor correspondant à la ligne de bit. Cela revient à connecter ou non la borne de source du transistor concerné reliée à la ligne de métallisation (ligne de bit), à la ligne de masse par l'intermédiaire de ce contact de source. Si ce contact est effectué, l'adressage du transistor correspondant provoquera la décharge vers la masse du potentiel de précharge. Dans le cas contraire, ce potentiel de précharge sera maintenu. Dans l'exemple de la figure 4B, on suppose que les transistors des cellules réalisées aux intersections de la ligne WLⱼ avec la colonne BLᵢ₊₂ et de la ligne WLⱼ₊₂ avec les colonnes BLᵢ₊₁ et BLᵢ₊₂ sont programmés à l'état zéro. Cela est illustré par des points sur les lignes de bit correspondantes, au niveau des sources de ces transistors.

Pour simplifier la représentation de la figure 4B, les lignes de bit BL ont été représentées parallèlement aux tronçons conducteurs contactant, dans la direction des lignes de bit et deux transistors sur trois, les sources de deux transistors voisins. En pratique, ces lignes et tronçons sont réalisés dans des niveaux de métallisation différents. Par exemple, les lignes de masse sont réalisées dans un premier niveau de métallisation tandis que les lignes de bit sont réalisées dans un deuxième niveau de métallisation. Les lignes de mot WL illustrées dans un niveau de diélectrique de formation des régions de grille sont bien entendu reprises dans un niveau de métallisation supérieur pour réaliser l'adressage.

Selon une variante de réalisation, les drains et sources sont inversés. Le contact qui n'est pas partagé avec la cellule voisine de la ligne de bit sert alors à effectuer la programmation.

La lecture des cellules mémoire d'une telle architecture s'effectue par groupes de trois lignes de bit dans chacun desquels seules deux lignes sont effectivement lues. La troisième des lignes n'est pas adressée (transistor à régions court-circuitées) et garde donc son potentiel (de préférence le niveau de précharge). On peut considérer qu'elle sert de ligne de référence à la lecture des deux autres. Selon la ligne de mot adressée, la ligne de bit servant de ligne de référence est différente par pas de trois lignes. Par la répétition du motif dans la direction des lignes de mot, chaque ligne de bit lue est encadrée d'une autre ligne lue et d'une ligne dont le niveau reste, pendant cette lecture à un potentiel fixe.

Un avantage de la présente invention est qu'elle permet d'équilibrer les courants sur les différents conducteurs de masse grâce à l'arrangement en diagonale de ces conducteurs. En effet, comme deux lignes de mot ne sont pas adressées en même temps, les cellules adressées des lignes de bit correspondant à l'intersection avec la ligne de mot appartiennent toutes à des conducteurs de masse différents. Par conséquent, chaque conducteur de masse ne véhicule que le courant d'une cellule, ce qui permet d'en réduire la taille.

Selon un premier mode de réalisation, la lecture des cellules s'effectue au moyen d'amplificateurs différentiels dont les deux entrées reçoivent la sortie de multiplexeurs trois vers deux pour sélectionner à chaque fois une ligne de référence et une ligne de donnée. Une même ligne de référence sert à deux lignes de données et est donc partagée par deux amplificateurs.

Les figures 5A, 5B et 5C représentent, de façon très schématique et sous forme de blocs, un exemple préféré d'organisation des cellules mémoire par groupes afin d'équilibrer les couplages entre les différentes lignes de bit. Les cellules sont regroupées par groupes G de cellules mémoire du type décrit en relation avec les figures 4A et 4C. Chaque groupe G comporte trois lignes de bit BL adjacentes et un nombre n quelconque de lignes de mot WL. Les groupes G sont connectés deux à deux verticalement (dans le sens des lignes de bit) soit sans croisement (bloc D, figure 5A) des lignes de bit BL, soit avec un croisement (bloc T, figure 5B) des lignes de bit BL tel que la première des trois lignes devient la dernière, la deuxième devient la première et la troisième devient la deuxième. Comme l'illustre la figure 5C, une colonne de groupes sur deux, tous les blocs sont reliés par une inversion des connexions des lignes de bit (bloc T) alors que dans les autres colonnes de groupes, la connexion verticale n'est pas modifiée (connexion D) un bloc sur trois.

Avec une telle architecture, les couplages entre les différentes lignes de bit se retrouvent équilibrés dans le plan mémoire. En effet, chaque ligne de bit de référence couplera équitablement les deux lignes voisines ainsi que les lignes des triplets précédent et suivant dans le sens des lignes de mot.

Un avantage de l'invention selon ce mode de réalisation préféré est qu'il résout non seulement les problèmes d'électromigration mais également les problèmes de couplage.

Un autre avantage de la présente invention est que l'architecture proposée permet de réduire le nombre de tranchées d'isolement (Shallow Trench Isolation ou STI) entre les transistors MOS, ce qui permet de diminuer le stress physique dans la structure et, par voie de conséquence, de réduire la taille pour un courant donné.

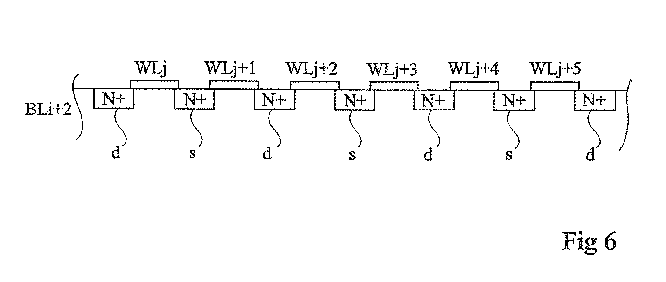

Cet avantage est illustré par la figure 6 qui représente, par une vue schématique et partielle à rapprocher de celle de la figure 3, un exemple de coupe d'un circuit intégré comprenant des transistors MOS de réalisation d'une mémoire selon un mode de réalisation de l'invention.

Comme l'illustre cette figure, aucune tranchée d'isolement n'est nécessaire dans le sens des lignes de bit. Dans l'exemple représenté, on considère le cas de la ligne BLᵢ₊₂. Les lignes de mot WLⱼ et WLⱼ₊₁ partagent leur source s, les lignes WLⱼ₊₁ et WLⱼ₊₂ partagent leur drain, etc. Ainsi, des tranchées d'isolement ne sont nécessaires que dans l'autre direction pour séparer les lignes de bit entre elles.

Bien entendu, la présente invention est susceptible de diverses variantes et modifications qui apparaîtront à l'homme de l'art. En particulier, bien que l'invention ait été décrite plus particulièrement en relation avec une mémoire de type contact, elle s'applique également à une mémoire de type via dans laquelle la sélection de programmation est effectuée par des vias reliant les lignes de métallisation aux prises de contact du circuit intégré. De plus, l'adaptation des décodeurs de colonnes et de rangées ainsi que des amplificateurs de lecture pour qu'ils partagent une même ligne de référence est à la portée de l'homme du métier à partir des indications fonctionnelles données ci-dessus.

## Revendications

1. Matrice de cellules mémoire à lecture seule constituées chacune d'un transistor dont une première région (d) de drain ou de source est connectée à une ligne de bit (BL) reliant plusieurs transistors dans une première direction, les grilles (g) des différents transistors étant connectées à des lignes de mot (WL) dans une deuxième direction perpendiculaire à la première, **caractérisée en ce qu'**elle comporte une répétition d'un motif élémentaire s'étendant sur trois lignes dans chaque direction et comportant neuf transistors disposés de façon que chacune des lignes du motif élémentaire comporte exactement deux cellules, deux transistors voisins de chaque motif dans la première direction partageant une même deuxième région (s) reliée à une ligne de masse reliée à des lignes de bit différentes d'une ligne de mot à l'autre.

2. Matrice selon la revendication 1, dans laquelle l'état d'une cellule dépend de la réalisation ou non d'une liaison entre la région (s) de son transistor reliée à la masse et la ligne de bit (BL).

3. Mémoire à lecture seule comportant une matrice selon la revendication 1 ou 2, **caractérisée en ce qu'**au moins une des extrémités d'un groupe (G) de trois colonnes du motif élémentaire est connectée à un dispositif de lecture (3) pour sélectionner, parmi les trois lignes de bit, deux lignes de bit à lire à partir de la ligne de mot adressée.

4. Mémoire selon la revendication 3, dans laquelle des groupes de cellules mémoire sont agencés par colonne en étant connectés de sorte que la première ligne de bit du premier groupe soit reliée à la troisième ligne de bit du deuxième groupe, la deuxième ligne de bit du premier groupe soit reliée à la première ligne de bit du deuxième groupe et la troisième ligne de bit du premier groupe soit reliée à la deuxième ligne de bit du deuxième groupe, une première colonne de groupes comportant de telles liaisons deux groupes sur trois verticalement tandis qu'une deuxième colonne voisine comporte une telle liaison entre chaque groupe.

5. Mémoire selon la revendication 1, dans laquelle la connexion à la masse des premières régions (s) est effectuée dans un premier niveau de métallisation tandis que les lignes de bit (BL) sont réalisées dans un deuxième niveau de métallisation, les liaisons entre les première et troisième lignes de bit entre les groupes étant réalisées dans un troisième niveau de métallisation.
